# EUROPEAN PATENT APPLICATION

(11) **EP 4 459 660 A1**
(43) Date of publication of application: **06.11.2024**
(21) Application number: 22915475.2
(22) Date of filing: 19.10.2022
(51) Int. Cl.: H01L 21/02, H01L 21/304

(54) **MOVEMENT MONITORING METHOD AND MANUFACTURING APPARATUS**

(30) Priority: 27.12.2021 JP 2021212536
(71) Applicant: SCREEN Holdings Co., Ltd., Kyoto-shi, Kyoto 602-8585 (JP)
(72) Inventor: OKAMOTO, Satoshi, Kyoto-shi, Kyoto 602-8585 (JP); FURUTA, Tomoyasu, Kyoto-shi, Kyoto 602-8585 (JP)
(74) Representative: Goddar, Heinz J.
(86) International application number: PCT/JP2022/038944
(87) International publication number: WO 2023/127240

(57) **Abstract**

Ther present invention provides a technique for evaluating high-speed motion included in an operation of a processing unit. Firstly, a specific operation of the processing unit is shot by an event-based camera (70). In this way, event data (E) is acquired, which includes information about only pixels whose luminance values have changed. Then, an evaluation value is calculated based on the event data (E). Thereafter, the specific operation of the processing unit is evaluated in accordance with the calculated evaluation value. The event data (E) has recorded therein information about high-speed motion included in the specific operation of the processing unit. Accordingly, it is possible to evaluate the high-speed motion in accordance with the evaluation value.

## Description

### [Technical Field]

The present invention relates to an operation monitoring method of monitoring an operation of a processing unit and a manufacturing apparatus including the processing unit.

### [Background Art]

The reproducibility of operations is an important issue for apparatuses such as industrial machinery. In particular, in apparatuses such as semiconductor manufacturing apparatuses that perform precision machining and micromachining on substrates, slight discrepancies in operation can be a cause of significant degradation of product quality. There is thus demand for quantitative evaluation of slight variations in operations to be performed by apparatuses.

Technology is conventionally known in which an apparatus is provided with a camera to monitor anomalies in operation. For example, Patent Literature (PTL) 1 discloses a technique for shooting a process for processing substrates by a camera and detecting the occurrence of anomalies in accordance with the captured moving image.

### [Citation List]

### [Patent Literature]

[PTL 1]
Japanese Patent Application Laid-Open No. 2014-165607

### [Summary of Invention]

### [Technical Problem]

The technique disclosed in PTL 1, however, uses a common frame-based camera. Thus, the camera according to PTL 1 captures a moving image composed of a plurality of frame images. Such a frame-based camera is incapable of shooting extremely high-speed motion such as a liquid flow. Therefore, it is difficult with the method disclosed in PTL 1 to evaluate high-speed motion included in the operation of a processing unit.

The present invention has been made in light of such circumstances, and it is an object of the present invention to provide a technique for evaluating high-speed motion included in the operation of a processing unit.

### [Solution to Problem]

To solve the problem described above, a first aspect of the present application is an operation monitoring method for monitoring an operation of a processing unit. The operation monitoring method includes a) acquiring event data by shooting a specific operation of the processing unit by an event-based camera, the event data including information about only a pixel whose luminance value has changed, b) calculating an evaluation value based on the event data, and c) evaluating the specific operation of the processing unit in accordance with the evaluation value.

A second aspect of the present application is the operation monitoring method according to the first aspect, in which in the operation a), a plurality of pieces of event data are acquired by shooting the specific operation performed in a plurality of processing units by the event-based camera, each of the plurality of pieces of event data being the event data, each of the plurality of processing units being the processing unit, in the operation b), the evaluation value is calculated for each of the plurality pieces of event data, and in the operation c), a variation in the specific operation of the plurality of processing units is evaluated in accordance with the evaluation value.

A third aspect of the present application is the operation monitoring method according to the second aspect further includes x) calculating a feature based on the information per unit time for each of the plurality of pieces of event data, and y) synchronizing timing of the plurality of pieces of event data with one another in accordance with a time-varying waveform of the feature. The operations x) and y) are performed after the operation a) and before the operation b).

A fourth aspect of the present application is the operation monitoring method according to the third aspect, in which the feature is the number of pixels whose luminance values have changed per unit time.

A fifth aspect of the present application is the operation monitoring method according to any one of the first to fourth aspects, in which the evaluation value is the number of pixels whose luminance values have changed in a predetermined evaluation region during a predetermined totaling time.

A sixth aspect of the present application is the operation monitoring method according to the fifth aspect, in which in the operation c), the specific operation of the processing unit is evaluated in accordance with a histogram obtained by totaling the number of pixels for each totaling time when there is a change in luminance value among a plurality of totaling times included in a predetermined inspection time, each of the plurality of totaling times being the predetermined totaling time.

A seventh aspect of the present application is the operation monitoring method according to the fifth or sixth aspect, in which the processing unit is a unit that supplies a processing liquid to a surface of a substrate, and the predetermined evaluation region includes the surface of the substrate during supply of the processing liquid.

An eighth aspect of the present application is the operation monitoring method according to the fifth or sixth aspect, in which the processing unit is a unit that supplies a processing liquid to a surface of a substrate, and the predetermined evaluation region includes a liquid column of the processing liquid ejected from a nozzle toward the substrate.

A ninth aspect of the present application is the operation monitoring method according to any one of the first to fourth aspects, in which the evaluation value is the number of pixel groups in which the number of adjacent pixels whose luminance values have changed in a predetermined evaluation region during a predetermined inspection time is greater than or equal to a predetermined lower limit value and less than or equal to a predetermined upper limit value.

A tenth aspect of the present application is the operation monitoring method according to the ninth aspect, in which the processing unit is a unit that supplies a processing liquid to a surface of a substrate, and the predetermined evaluation region includes an outer edge of the substrate.

An eleventh aspect of the present application is the operation monitoring method according to any one of the first to fourth aspects, in which the evaluation value is the number of pixels whose luminance values have changed in a predetermined evaluation time during a predetermined totaling time, and in the operation c), the specific operation of the processing unit is evaluated based on a time-varying change of the evaluation value.

A twelfth aspect of the present application is the operation monitoring method according to the eleventh aspect, in which the processing unit is a unit that supplies a processing liquid to a surface of a substrate, and the predetermined evaluation region includes the surface of the substrate during dry processing of shaking off the processing liquid while rotating the substrate.

A thirteenth aspect of the present application is a manufacturing apparatus that includes a processing unit that processes an object to be processed, by performing a specific operation, an event-based camera capable of outputting event data that includes information about only a pixel whose luminance value has changed, and a computer that is communicably connected to the event-based camera. The manufacturing apparatus causes the computer to execute a) processing for acquiring the event data by causing the event-based camera to shoot the specific operation of the processing unit, b) processing for calculating an evaluation value based on the event data, and c) processing for evaluating the specific operation of the processing unit in accordance with the evaluation value.

### [Advantageous Effects of Invention]

According to the first to thirteenth aspects of the present application, the event-based camera shoots the specific operation of the processing unit. Then, the evaluation value is calculated based on the obtained event data. The event data has recorded therein information about high-speed motion included in the specific operation of the processing unit. Accordingly, it is possible to evaluate the high-speed motion in accordance with the evaluation value.

In particular, according to the second aspect of the present application, it is possible to evaluate variations in the specific operation of the plurality of processing units.

In particular, according to the third aspect of the present application, the timing of the plurality of pieces of event data are synchronized with one another. This allows the variations in the specific operation of the processing units to be accurately evaluated in the operations b) and c). Besides, the feature for use in synchronizing the timing of the plurality of pieces of event data with one another is calculated based on the information included in the event data. This eliminates the need to measure, separately from the event data, other parameters for use in synchronizing the timing of the plurality of pieces of event data with one another.

### [Brief Description of Drawings]

Fig. 1 is a plan view of a substrate processing apparatus.
Fig. 2 is a longitudinal sectional view of one processing unit.
Fig. 3 is a diagram schematically showing how an event-based camera captures an image.
Fig. 4 is a block diagram showing connection between a controller and each constituent element of one processing unit.
Fig. 5 is a flowchart showing a procedure for processing a substrate.
Fig. 6 is a flowchart showing a procedure for operation monitoring.
Fig. 7 is a diagram showing an example of one frame image.
Fig. 8 is a diagram showing an example of imaging event data.
Fig. 9 is a graph showing an example of a time-varying waveform of a feature.
Fig. 10 is a flowchart showing a processing procedure performed when evaluating a surface state of a substrate during supply of a processing liquid.
Fig. 11 is a diagram showing an example of a histogram.
Fig. 12 is a flowchart showing a processing procedure performed when evaluating a liquid column state during supply of a processing liquid.
Fig. 13 is a diagram showing an example of a histogram.
Fig. 14 is a flowchart showing a processing procedure performed when evaluating a liquid splash state.
Fig. 15 is a diagram showing an example of detecting a pixel group that corresponds to a liquid splash.
Fig. 16 is a flowchart showing a processing procedure performed when evaluating a surface state of a substrate during dry processing.
Fig. 17 is a graph showing an example of a time-varying waveform of an evaluation value.

### [Description of Embodiment]

Hereinafter, an embodiment of the present invention will be described in detail with reference to the drawings.

### 1. Overall Configuration of Substrate Processing Apparatus

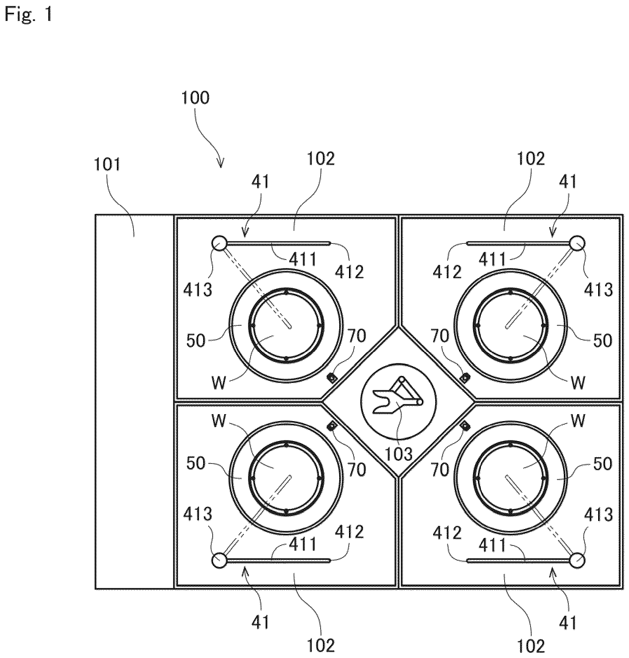

Fig. 1 is a plan view of a substrate processing apparatus 100 as an example of a manufacturing apparatus according to the present invention. The substrate processing apparatus 100 is an apparatus for processing surfaces of disk-like substrates W (silicon wafers) by supplying a processing liquid to the surfaces of the substrates W during the process of manufacturing the semiconductor wafers. As shown in Fig. 1, the substrate processing apparatus 100 includes an indexer 101, a plurality of processing units 102, and a main transport robot 103.

The indexer 101 is a part for transporting unprocessed substrates W into the apparatus from the outside and transporting processed substrates W to the outside of the apparatus. The indexer 101 includes a plurality of carriers arranged therein, each carrier housing a plurality of substrates W therein. The indexer 101 also includes a transfer robot which is not shown. The transfer robot transfers substrates W between the carriers in the indexer 101 and either the processing units 102 or the main transport robot 103.

Each processing unit 102 is a so-called sheet-fed processing part for processing substrates W one by one. The processing units 102 are arranged around the main transport robot 103. In the present embodiment, three layers of processing units 102 are stacked one above another in a height direction, each layer including four processing units 102 arranged around the main transport robot 103. That is, the substrate processing apparatus 100 according to the present embodiment includes 12 processing units 102 in total. Each processing unit 102 processes a plurality of substrates W in parallel. It is, however, noted that the number of processing units 102 included in the substrate processing apparatus 100 is not limited to 12, and may be any number such as 1, 4, 8, or 24.

The main transport robot 103 is a mechanism for transporting substrates W between the indexer 101 and the processing units 102. For example, the main transport robot 103 may include a hand for holding a substrate W and an arm for moving the hand. The main transport robot 103 takes unprocessed substrates W out of the indexer 101 and transfers these substrates W to the processing units 102. When the processing units 102 have completed the processing of the substrates W, the main transport robot 103 takes the processed substrates W out of the processing units 102 and transfers these substrates W to the indexer 101.

### 2. Configuration of Processing Unit

Next is a description about a detailed configuration of the processing units 102. While the following description is given about one of the processing units 102 included in the substrate processing apparatus 100, the other processing units 102 also have equivalent configurations.

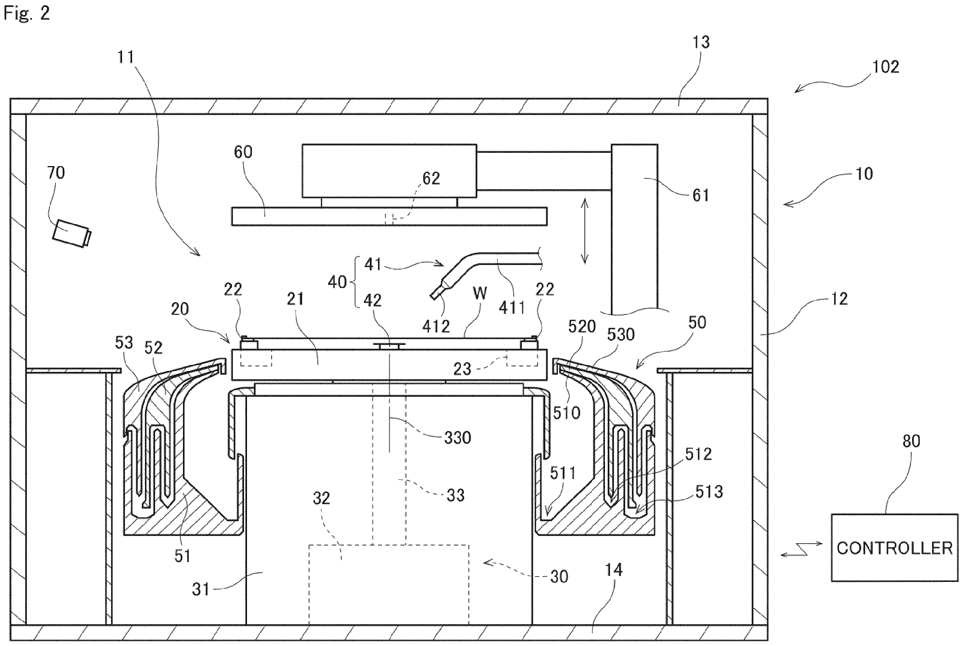

Fig. 2 is a longitudinal sectional view of one processing unit 102. As shown in Fig. 2, the processing unit 102 includes a chamber 10, a substrate holder 20, a rotation mechanism 30, a processing liquid supplier 40, a processing liquid collector 50, a barrier plate 60, an event-based camera 70, and a controller 80.

The chamber 10 is a casing that has a processing space 11 for processing substrates W. The chamber 10 has a side wall 12 that surrounds the sides of the processing space 11, a top plate 13 that covers the top of the processing space 11, and a bottom plate 14 that covers the bottom of the processing space 11. The substrate holder 20, the rotation mechanism 30, the processing liquid supplier 40, the processing liquid collector 50, the barrier plate 60, and the event-based camera 70 are housed in the chamber 10. The side wall 12 is provided with a transport entrance and a shutter, the transport entrance being an entrance for transporting substrates W into and out of the chamber 11, the shutter being a mechanism for opening and closing the transport entrance.

The substrate holder 20 is a mechanism for holding substrates W horizontally (in such a posture that the normal is oriented in the vertical direction) inside the chamber 10. As shown in Fig. 2, the substrate holder 20 includes a disk-like spin base 21 and a plurality of chuck pins 22. The chuck pins 22 are provided at equiangular intervals along the outer periphery of the upper surface of the spin base 21. The substrate W is held by the chuck pins 22 so that the surface to be processed where a pattern is formed faces upward. Each chuck pin 22 comes in contact with the lower surface of the edge portion of the substrate W and with the outer peripheral end face of the substrate W and supports the substrate W at a position above the upper surface of the spin base 21 with a slight gap therebetween.

The spin base 21 includes a chuck-pin switching mechanism 23 for switching the positions of the chuck pins 22. The chuck-pin switching mechanism 23 switches the chuck pins 22 between a holding position at which the chuck pins 22 hold the substrate W and a release position at which the chuck pins 22 release the hold of the substrate W.

The rotation mechanism 30 is a mechanism for rotating the substrate holder 20. The rotation mechanism 30 is housed in a motor cover 31 provided below the spin base 21. As indicated by broken lines in Fig. 2, the rotation mechanism 30 includes a spin motor 32 and a support shaft 33. The support shaft 33 extends in the vertical direction and has its lower end connected to the spin motor 32 and its upper end fixed to the center of the lower surface of the spin base 21. When the spin motor 32 is driven, the support shaft 33 rotates about the shaft center 330. Together with the support shaft 33, the substrate holder 20 and the substrate W held by the substrate holder 20 also rotate about the shaft center 330.

The processing liquid supplier 40 is a mechanism for supplying a processing liquid to the upper surface of the substrate W held by the substrate holder 20. The processing liquid supplier 40 includes a top nozzle 41 and a bottom nozzle 42. As shown in Figs. 1 and 2, the top nozzle 41 includes a nozzle arm 411, a nozzle head 412 provided at the tip of the nozzle arm 411, and a nozzle motor 413. The nozzle arm 411 is driven by the nozzle motor 413 so as to move angularly in the horizontal direction about the root end of the nozzle arm 411. This allows the nozzle head 412 to move between a processing position located above the substrate W held by the substrate holder 20 (positions indicated by chain double-dashed lines in Fig. 1) and a retracted position located outward of the processing liquid collector 50 (positions indicated by solid lines in Fig. 1).

The nozzle head 412 is connected to a liquid supplier (not shown) for supplying a processing liquid. Examples of the processing liquid that may be used include an SPM cleaning liquid (a mixed solution of a sulfuric acid and hydrogen peroxide water), an SC-1 cleaning liquid (a mixed solution of aqueous ammonia, hydrogen peroxide water, and pure water), an SC-2 cleaning liquid (a mixed solution of a hydrochloric acid, hydrogen peroxide water, and pure water), a DHF cleaning liquid (a dilute hydrofluoric acid), and pure water (deionized water). When a valve of the liquid supplier is opened with the nozzle head 412 placed at the processing position, the processing liquid supplied from the liquid supplier is ejected from the nozzle head 412 toward the upper surface of the substrate W held by the substrate holder 20.

Note that the nozzle head 412 may be a so-called two-fluid nozzle that mixes the processing liquid with a pressurized gas to generate droplets and ejects a resultant mixed fluid of the droplets and the pressurized gas to the substrate W. As another alternative, each processing unit 102 may include a plurality of top nozzles 41.

The bottom nozzle 42 is arranged inward of a through hole provided in the center of the spin base 21. The bottom nozzle 42 has an ejection outlet that faces the lower surface of the substrate W held by the substrate holder 20. The bottom nozzle 42 is also connected to the liquid supplier for supplying the processing liquid. When the processing liquid is supplied from the liquid supplier to the bottom nozzle 42, the bottom nozzle 42 ejects the processing liquid toward the lower surface of the substrate W.

The processing liquid collector 50 is a part for collecting the used processing liquid. As shown in Fig. 2, the processing liquid collector 50 includes an inner cup 51, an intermediate cup 52, and an outer cup 53. The inner cup 51, the intermediate cup 52, and the outer cup 53 are movable up and down independently of one another by an elevating mechanism which is not shown.

The inner cup 51 includes a circular ring-shaped first guide plate 510 that surrounds the periphery of the substrate holder 20. The intermediate cup 52 includes a circular ring-shaped second guide plate 520 that is located outward and upward of the first guide plate 510. The outer cup 53 includes a circular ring-shaped third guide plate 530 that is located outward and upward of the second guide plate 520. The bottom of the inner cup 51 extends to below the bottoms of the intermediate cup 52 and the outer cup 53. The upper surfaces of these bottoms are provided with a first drain groove 511, a second drain groove 512, and a third drain groove 513 in order from the inner side.

The processing liquid ejected from the top and bottom nozzles 41 and 42 of the processing liquid supplier 40 is supplied to the substrate W and scattered to the outside by centrifugal force caused by rotation of the substrate W. The processing liquid scattered from the substrate W is collected by one of the first guide plate 510, the second guide plate 520, and the third guide plate 530. The processing liquid collected by the first guide plate 510 is discharged through the first drain groove 511 to the outside of the processing unit 102. The processing liquid collected by the second guide plate 520 is discharged through the second drain groove 512 to the outside of the processing unit 102. The processing liquid collected by the third guide plate 530 is discharged through the third drain groove 513 to the outside of the processing unit 102.

In this way, the processing unit 102 includes a plurality of passages for discharging processing liquids. Thus, the processing unit 102 is capable of sorting and collecting processing liquids supplied to the substrate W for each type. Accordingly, collected processing liquids can also be separately disposed of or regenerated depending on the properties of each processing liquid.

The barrier plate 60 is a member for suppressing diffusion of a gas in the vicinity of the surface of the substrate W during certain processing such as dry processing. The barrier plate 60 has a disk-like outside shape and is arranged horizontally above the substrate holder 20. As shown in Fig. 2, the barrier plate 60 is connected to an elevating mechanism 61. When the elevating mechanism 61 is operated, the barrier plate 60 moves up and down between an upper position at which the barrier plate 60 is spaced above from the upper surface of the substrate W held by the substrate holder 20 and a lower position at which the barrier plate 60 is closer to the upper surface of the substrate W than when being at the upper position. For example, the elevating mechanism 61 may be a mechanism for converting rotational motion of a motor into translatory motion by means of a ball screw.

The barrier plate 60 has an air outlet 62 in the center of its lower surface, the air outlet 62 being an outlet from which a gas for drying (hereinafter, referred to as the "drying gas") is issued. The air outlet 62 is connected to a gas supplier (not shown) that supplies the drying gas. The drying gas may, for example, be a heated nitrogen gas.

When the processing liquid is supplied from the top nozzle 41 to the substrate W, the barrier plate 60 retracts to the upper position. When dry processing is performed on the substrate W after the supply of the processing liquid, the elevating mechanism 61 moves the barrier plate 60 down to the lower position. Then, the drying gas is issued from the air outlet 62 toward the upper surface of substrate W. At this time, the barrier plate 60 prevents the diffusion of the gas. As a result, the drying gas is efficiently supplied to the upper surface of the substrate W.

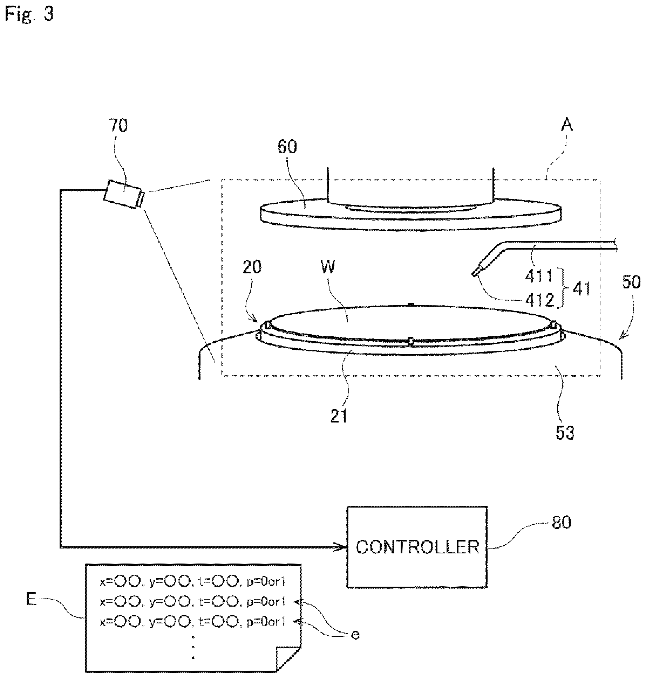

The event-based camera 70 is a device that shoots a specific operation performed in the chamber 10. For example, the event-based camera 70 may be installed in a position that is in close proximity to the inner surface of the side wall 12 of the chamber 10. Fig. 3 is a diagram schematically showing how the event-based camera 70 captures an image. In the present embodiment, a rectangular region that includes the nozzle head 412 and the substrate W supported by the spin base 21 is assumed to be an image capture region A of the event-based camera 70. In the operation of ejecting the processing liquid from the nozzle head 412 to the surface of the substrate W or in the operation of drying the substrate W, the event-based camera 70 shoots this operation performed within the image capture region A.

A common camera for capturing a moving image (frame-based camera) outputs moving image data in which frame images are aligned in time sequence, each frame image including information about the luminance values of a large number of pixels. In contrast, the event-based camera 70 outputs event data E that includes information about only pixels whose luminance values have changed. The event data E is composed of a plurality of pieces of single data e that is generated only when there is a change in luminance value. As shown in Fig. 3, each piece of single data e is composed of information that indicates coordinates x and y of a pixel whose luminance value has changed, time t when the luminance value has changed, and the direction of change p in the luminance value. The direction of change p in the luminance value takes a value of "1" when the luminance value has changed in the direction of increasing luminance, and takes a value of "0" when the luminance value has changed in the direction of decreasing luminance.

In this way, the event-based camera 70 outputs information about only the pixels whose luminance values have changed. Thus, the amount of information in the event data E, which is output from the event-based camera 70, is smaller than the amount of information in the moving image output from the frame-based camera. Thus, the use of the event-based camera 70 increases the speed of data acquisition and data transfer as compared to the case of using the frame-based camera. The event-based camera 70 is also capable of acquiring pieces of single data e at shorter time intervals (e.g., every several microseconds) than the time intervals of acquiring frame images acquired by the frame-based camera. Accordingly, the use of the event-based camera 70 enables capturing high-speed motion of the object to be shot.

The event-based camera 70 transmits the captured event data E to the controller 80.

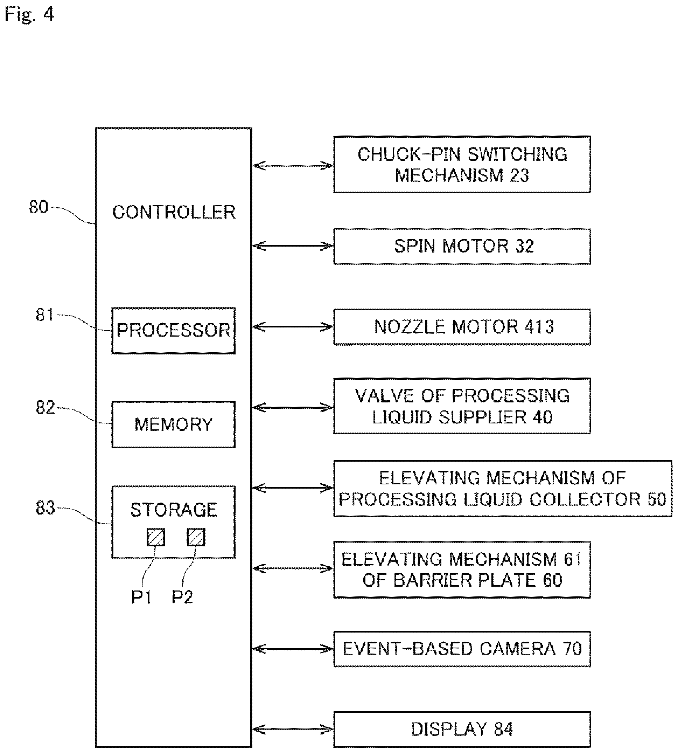

The controller 80 is means for controlling operations of each constituent element of the processing unit 102. Fig. 4 is a block diagram showing electrical connection between the controller 80 and each constituent element of the processing unit 102. As schematically shown in Fig. 4, the controller 80 is configured as a computer that includes a processor 81 such as a CPU, memory 82 such as RAM, and a storage 83 such as a hard disk drive.

The storage 83 stores an operation control program P1 and an operation monitoring program P2. The operation control program P1 is a computer program for controlling operations of each constituent element of the processing unit 102 in order to allow the processing unit 102 to perform processing on the substrate W. The operation monitoring program P2 is a computer program for monitoring and evaluating a specific operation performed in the processing unit 102 in accordance with the event data E obtained from the event-based camera 70. The operation control program P1 and the operation monitoring program P2 are read out from a computer-readable storage medium such as a CD or a DVD and stored in the storage 83. Alternatively, the operation control program P1 and the operation monitoring program P2 may be downloaded into the controller 80 via a network.

As shown in Fig. 4, the controller 80 is communicably connected via a cable or wirelessly to each of the aforementioned constituent elements including the chuck-pin switching mechanism 23, the spin motor 32, the nozzle motor 413, the valve of the processing liquid supplier 40, the elevating mechanism of the processing liquid collector 50, the elevating mechanism 61 of the barrier plate 60, and the event-based camera 70. The controller 80 is also electrically connected to a display 84 such as a liquid crystal display. The controller 80 controls the operations of the above-described constituent elements in accordance with the operation control program P1 and the operation monitoring program P2, which are stored in the storage 83. In this way, processing in steps S1 to S5, in steps S11 to S 15, in steps S21 to S25, in steps S31 to S3 5, in steps S41 to S46, and in steps S51 to S55 proceed, which will be described later.

### 3. Operations of Substrate Processing Apparatus

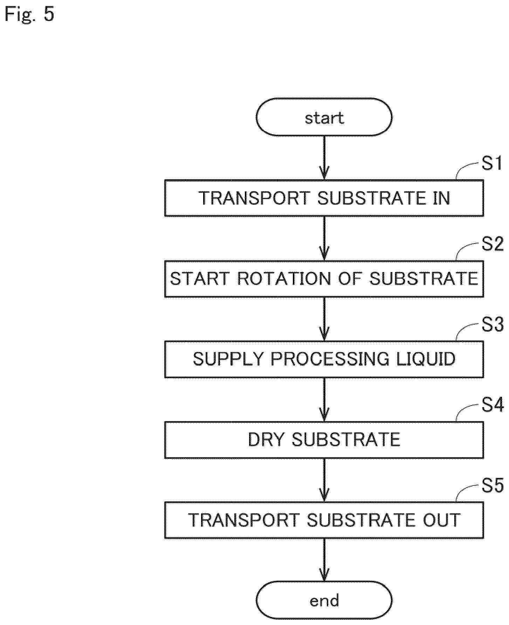

Next is a description of the processing performed on the substrate W in the processing unit 102 described above. Fig. 5 is a flowchart showing a procedure for processing the substrate W.

In the case of processing a substrate W in a processing unit 102, firstly, the main transport robot 103 transports a substrate W to be processed into the chamber 10 (step S1). The substrate W transported into the chamber 10 is horizontally held by the chuck pins 22 of the substrate holder 20. Thereafter, the spin motor 32 of the rotation mechanism 30 is driven so as to start rotation of the substrate W (step S2). Specifically, the support shaft 33, the spin base 21, the chuck pins 22, and the substrate W held by the chuck pins 22 rotate about the shaft center 330 of the support shaft 33.

Then, a processing liquid is supplied from the processing liquid supplier 40 (step S3). In step S3, the nozzle motor 413 is driven so as to move the nozzle head 412 to the processing position facing the upper surface of the substrate W. Then, the processing liquid is ejected from the nozzle head 412 placed at the processing position. The storage 83 in the controller 80 stores parameters such as an ejection rate and an ejection time of the processing liquid in advance. In accordance with these settings, the controller 80 performs the operation of ejecting the processing liquid from the top nozzle 41.

In step S3, the top nozzle 41 may swing in the horizontal direction at the processing position while ejecting the processing liquid. The processing liquid may also be ejected from the bottom nozzle 42 as necessary.

During the process of supplying the processing liquid in step S3, the barrier plate 60 is placed at the upper position above the top nozzle 41. When the supply of the processing liquid to the substrate W is completed and the top nozzle 41 is placed at the retracted position, the controller 80 operates the elevating mechanism 61 so as to move the barrier plate 60 from the upper position to the lower position. Then, the number of revolutions of the spin motor 32 is increased to enhance the speed of rotation of the substrate W, and the drying gas is issued toward the substrate W from the air outlet 62 provided in the lower surface of the barrier plate 60. In this way, the surface of the substrate W is dried (step S4).

When the dry processing of the substrate W is completed, the spin motor 32 is stopped to stop the rotation of the substrate W. Then, the chuck pins 22 release the hold of the substrate W. Thereafter, the main transport robot 103 takes the processed substrate W out of the substrate holder 20 and transports this substrate W to the outside of the chamber 10 (step S5).

Each processing unit 102 performs the above-described processing in steps S1 to S5 repeatedly on a plurality of substrates W that are transported in sequence.

### 4. Operation Monitoring

Next is a description of an operation monitoring function of the substrate processing apparatus 100. The operation monitoring function is a function of monitoring a specific operation repeatedly performed in the processing units 102 and detecting variations in the specific operation (machine-to-machine differences) among the processing units 102. In the following description, the operation to be monitored is regarded as either the aforementioned operation of supplying the processing liquid in step S3 or the aforementioned drying operation in step S4. It is, however, noted that the operation to be monitored may be any operation other than the operation of supplying the processing liquid and the drying operation.

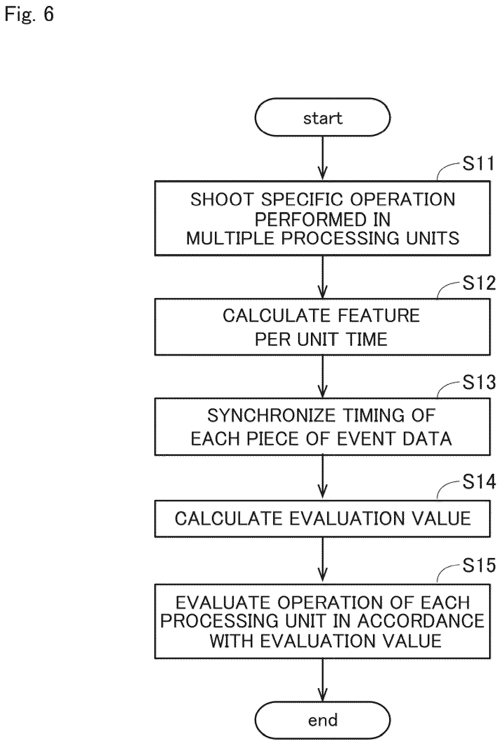

Fig. 6 is a flowchart showing the procedure for operation monitoring. The substrate processing apparatus 100 firstly causes the processing units 102 to perform a specific operation. Then, the event-based camera 70 of each processing unit 102 shoots this operation multiple times (step S11). In this way, a plurality of pieces of event data E are acquired. The specific operation as used herein may be an operation that is performed on the substrate W as a product, or may be an operation that is performed on an adjustive dummy substrate for use in adjustment of the processing unit 102. The event-based camera 70 of each processing unit 102 transmits the obtained event data E to the controller 80. The controller 80 stores the plurality of pieces of event data E transmitted from the event-based cameras 70 in the storage 83.

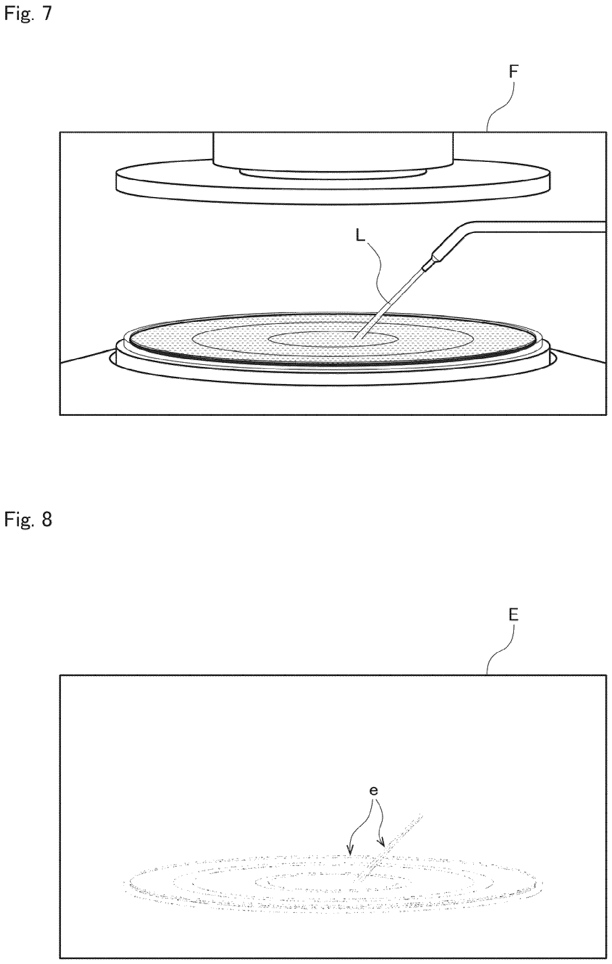

Fig. 7 is a diagram showing an example of one frame image F in the case of shooting the image capture region A in the processing unit 102 by a common frame-based camera. Fig. 8 is a diagram showing an example of shooting the same image capture region A by the event-based camera 70 and imaging the resultant event data E. In Fig. 8, pixels in which single data e of the event data E exists are indicated by black dots.

In the common frame image F, the luminance value is defined for each pixel. Thus, an area where there is no motion also appears in the common frame image F as shown in Fig. 7. In contrast, the event data E includes information about only pixels whose luminance values have changed. Thus, in the event data E, the single data e exists only in an area where there is motion, and does not exist in an area where there is no motion as shown in Fig. 8.

Then, for each of a plurality of pieces of event data E, the controller 80 calculates a feature based on the information about the single data e per unit time (step S12). In step S12, the controller 80 totals the number of pieces of single data e per unit time for each piece of event data E. The unit time is a duration of time greater than the time interval of acquiring the single data e by the event-based camera 70 and may, for example, be approximately five seconds. The controller 80 regards, as the feature, the number of pieces of single data e included in the event data E per unit time. That is, the controller 80 regards, as the feature, the number of pixels whose luminance values have changed per unit time. It is, however, noted that the feature may be any other numeric value calculated based on the event data E.

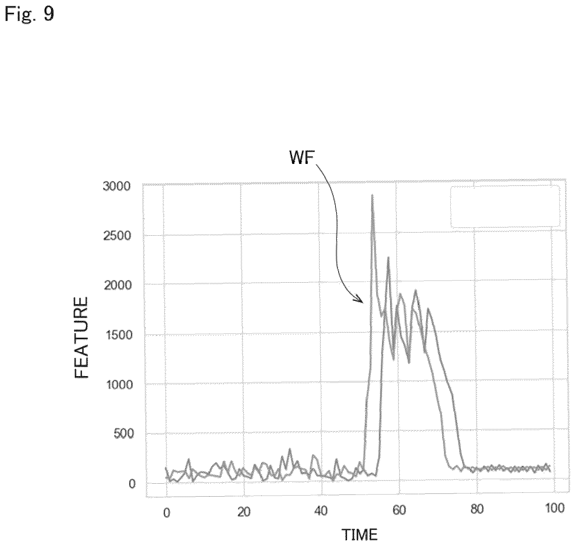

When the feature is calculated per unit time for each piece of event data E, a time-varying waveform WF of the feature is obtained for each piece of event data E. Fig. 9 is a graph showing an example of the time-varying waveforms WF of features calculated for two pieces of event data E. In the graph in Fig. 9, the horizontal axis represents the time, and the vertical axis represents the feature.

The controller 80 synchronizes the timing of the plurality of pieces of event data E with one another by comparing the time-varying waveforms WF of the features calculated for the plurality of pieces of event data E (step S 13). Specifically, the controller 80 obtains a cross-correlation function of the time-varying waveform WF calculated for one piece of event data E that serves as a reference and the time-varying waveform WF calculated for the other pieces of event data E. Then, the controller 80 obtains the amount of time deviation for which the cross-correlation function takes a maximum value. Thereafter, the controller 80 shifts the times of the other pieces of event data E in order to resolve the amount of time deviation. Accordingly, the timing of operations in the plurality of pieces of event data E are synchronized with the timing of operation in the event data E serving as a reference. That is, the same operation is performed at the same time in the plurality of pieces of event data E.

When the timing of the pieces of event data E is synchronized, then, the controller 80 calculates an evaluation value for each piece of event data E (step S14). Then, the controller 80 evaluates a specific operation of each processing unit 102 in accordance with the calculated evaluation value (step S15). The evaluation value may be any value that is calculated based on the event data E. The controller 80 calculates the evaluation value by a calculation method that is preset in response to an event to be evaluated in the specific operation of the processing unit 102.

Hereinafter, the processing in steps S14 and S15 will be described in more detail with reference four examples that show different events to be evaluated.

### 4-1. Case of Evaluating Surface State of Substrate during Supply of Processing Liquid

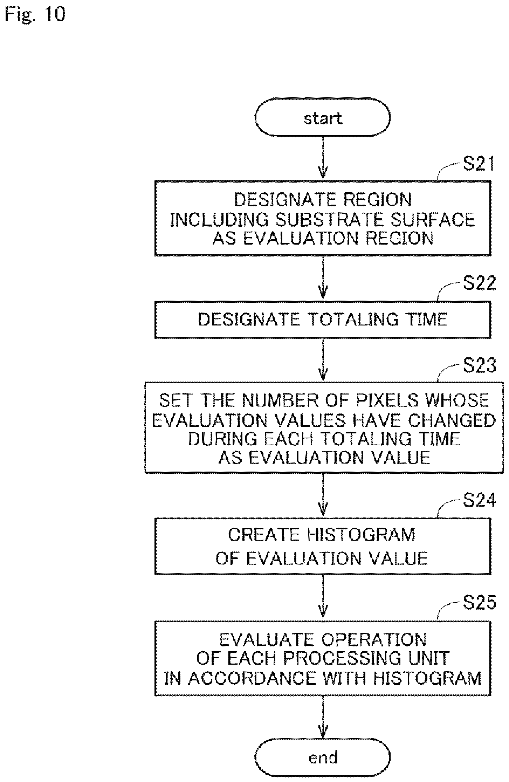

When the processing liquid is supplied from the top nozzle 41 to the surface of a substrate W, a high-speed flow of the processing liquid is formed along the surface of the substrate W. The following description is given about the case of evaluating the surface state of the substrate W at that time. Fig. 10 is a flowchart showing a processing procedure performed when evaluating the surface state of the substrate W during supply of the processing liquid.

As shown in Fig. 10, the controller 80 first designates an evaluation region (step S21). For example, the evaluation region may be designated in accordance with information that is input to the controller 80 by the user. In the present example, a region of the image capture region A that includes the surface of the substrate W during supply of the processing liquid is designated as the evaluation region.

Then, the controller 80 designates a totaling time (step S22). For example, the totaling time may be designated in accordance with information that is input to the controller 80 by the user. The totaling time is a duration of time greater than the time interval of acquiring the single data e by the event-based camera 70. In the case of evaluating the surface state of the substrate W during supply of the processing liquid, the totaling time may be set to, for example, one second.

Then, the controller 80 counts the number of pixels whose luminance values have changed in the designated evaluation region during each designated totaling time. Specifically, the controller 80 totals the number of pieces of single data e that includes coordinate information x, y included in the designated evaluation region and time information t that matches the designated totaling time among a plurality of pieces of single data e included in the event data E. It is, however, noted that a plurality of pieces of single data e that include the same coordinate information x, y are counted as one piece of single data e. That is, even if the luminance value of one pixel has changed multiple times during one totaling time, the count is incremented just by one. Then, the controller 80 sets the totaled number of pieces of single data e (i.e., the number of pixels whose luminance values have changed) as the evaluation value (step S23).

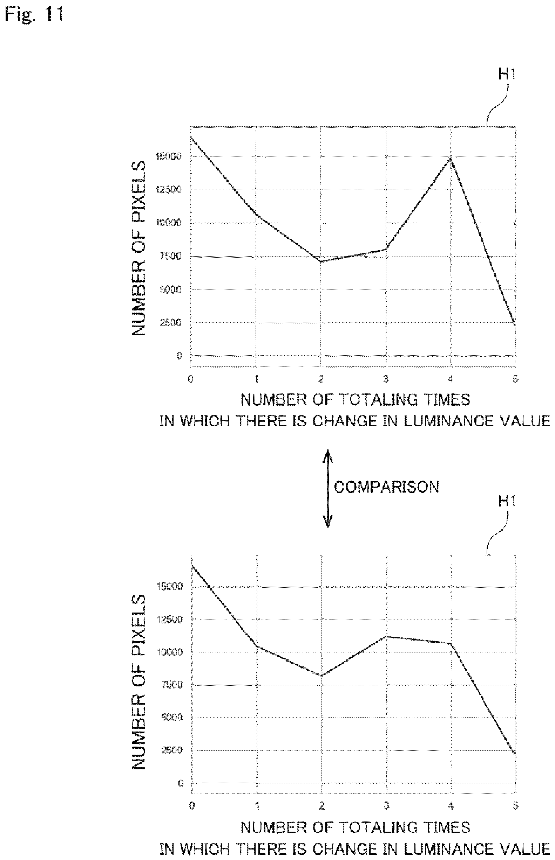

Then, the controller 80 creates a histogram H1 of the above evaluation value (step S24). Fig. 11 is a diagram showing an example of histograms H1 created for two processing units 102. In the example in Fig. 11, an inspection period for creating the histograms H1 is set to five seconds. The horizontal axis in each histogram H1 represents the number of totaling times in which there is a change in luminance value among five totaling times included in the inspection time. The vertical axis in each histogram H1 represents the number of pixels.

That is, the histograms H1 in Fig. 11 show the number of pixels among a plurality of pixels included in the evaluation region for the case where the number of totaling times in which there is a change in luminance value is zero during the 5-second inspection time, the number of pixels for the case where the number of totaling times in which there is a change in luminance value is one, the number of pixels for the case where the number of totaling times in which there is a change in luminance value is two, the number of pixels for the case where the number of totaling times in which there is a change in luminance value is three, the number of pixels for the case where the number of totaling times in which there is a change in luminance value is four, and the number of pixels for the case where the number of totaling times in which there is a change in luminance value is five.

The creation of these histograms H1 allows the tendency of changes in the luminance values of a large number of pixels included in the evaluation region to be expressed statistically by a single graph. The controller 80 evaluates the operation of each processing unit 102 in accordance with the created histogram H1 (step S25).

In step S25, the controller 80 compares the histograms H1 created for each processing unit 102. The controller 80 then determines whether a difference between the histogram H1 created for a processing unit 102 that serves as a reference and the histogram H1 created for a different processing unit 102 falls within a preset tolerance. Then, if the difference between the histograms H1 deviates from the tolerance, the controller 80 determines that there is a wide range of variations in operation (machine-to-machine difference) between those processing units 102. Thereafter, the controller 80 displays the evaluation result on the display 84.

4-2. Case of Evaluating State of Liquid Column during Supply of Processing Liquid

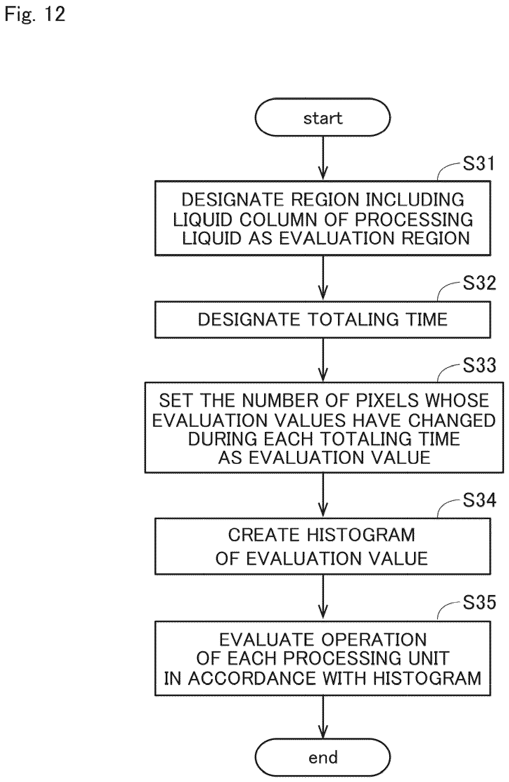

When the processing liquid is supplied from the top nozzle 41 to the surface of the substrate W, a liquid column L of the processing liquid ejected from the nozzle head 412 is formed between the nozzle head 412 and the substrate W as shown in Fig. 8. The following description is given about the case of evaluating the state of this liquid column L such as staggering. Fig. 12 is a flowchart showing a processing procedure performed when evaluating the state of the liquid column L during supply of the processing liquid.

As shown in Fig. 12, the controller 80 first designates an evaluation region (step S31). For example, the evaluation region may be designated in accordance with information that is input to the controller 80 by the user. In the present example, a region of the image capture region A that includes the liquid column L of the processing liquid ejected from the top nozzle 41 toward the substrate W is designated as the evaluation region.

Then, the controller 80 designates a totaling time (step S32). For example, the totaling time may be designated in accordance with information that is input to the controller 80 by the user. The totaling time is a duration of time greater than the time interval of acquiring the single data e by the event-based camera 70. In the case of evaluating the state of the liquid column L during supply of the processing liquid, the totaling time may be set to, for example, one second.

Then, the controller 80 counts the number of pixels whose luminance values have changed in the designated evaluation region during each designated totaling time. Specifically, the controller 80 totals the number of pieces of single data e that includes coordinate information x, y included in the designated evaluation region and time information t that matches the designated totaling time among a plurality of pieces of single data e included in the event data E. It is, however, noted that a plurality of pieces of single data e that include the same coordinate information x, y are counted as one piece of single data e. That is, even if the luminance value of one pixel has changed multiple times during one totaling time, the counter is incremented just by one. Then, the controller 80 sets the totaled number of pieces of single data e (i.e., the number of pixels whose luminance values have changed) as the evaluation value (step S33).

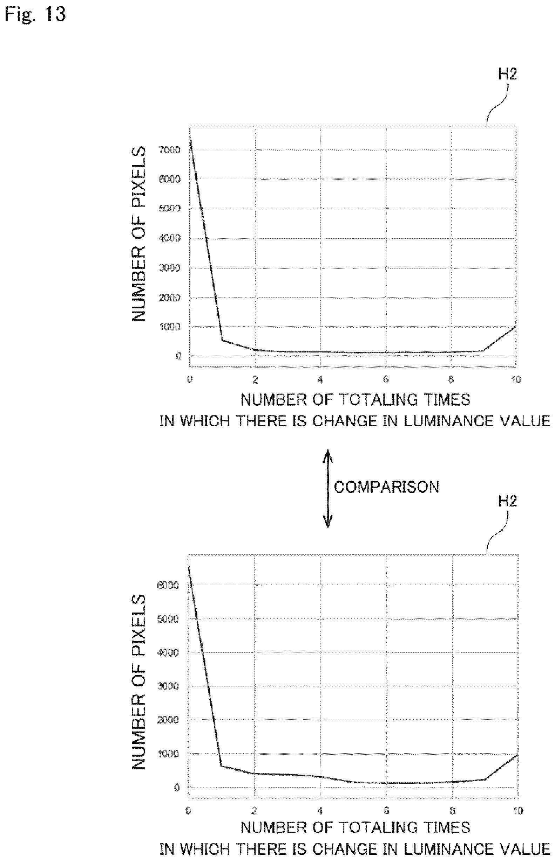

Then, the controller 80 creates a histogram H2 of the above evaluation value (step S34). Fig. 13 is a diagram showing an example of histograms H2 created for two processing units 102. In the example in Fig. 13, an inspection time for creating the histograms H2 is set to 10 seconds. The horizontal axis in each histogram H2 represents the number of totaling times in which there is a change in luminance values among 10 totaling times included in the inspection time. The vertical axis in each histogram H2 represents the number of pixels.

That is, each histogram H2 in Fig. 13 show the number of pixels among a plurality of pixels included in the evaluation region for the case where the number of totaling times in which there is a change in luminance value is zero during the 10-second inspection time, the number of pixels for the case where the number of totaling times in which there is a change in luminance value is one, the number of pixels for the case where the number of totaling times in which there is a change in luminance value is two, the number of pixels for the case where the number of totaling times in which there is a change in luminance values is three, the number of pixels for the case where the number of totaling times in which there is a change in luminance value is four, the number of pixels for the case where the number of totaling times in which there is a change in luminance value is five, the number of pixels for the case where the number of totaling times in which there is a change in luminance values is six, the number of pixels for the case where the number of totaling times in which there is a change in luminance value is seven, the number of pixels for the case where the number of totaling times in which there is a change in luminance value is eight, the number of pixels for the case where the number of totaling times in which there is a change in luminance values is nine, the number of pixels for the case where the number of totaling times in which there is a change in luminance value is ten.

The creation of these histograms H2 allows the tendency of changes in the luminance values of a large number of pixels included in the evaluation region to be expressed statistically by a single graph. The controller 80 evaluates the operation of each processing unit 102 in accordance with the created histogram H2 (step S35).

In step S35, the controller 80 compares the histograms H2 created for each processing unit 102. Then, the controller 80 determines whether a difference between the histogram H2 created for a processing unit 102 that serves as a reference and the histogram H2 created for the different processing unit 102 falls within a preset tolerance. If the difference between the histograms H2 deviates from the tolerance, the controller 80 determines that there is a wide range of variations in operation (machine-to-machine difference) between the processing units 102. Thereafter, the controller 80 displays the evaluation result on the display 84.

### 4-3. Case of Evaluating Liquid Splash Made by Chuck Pins

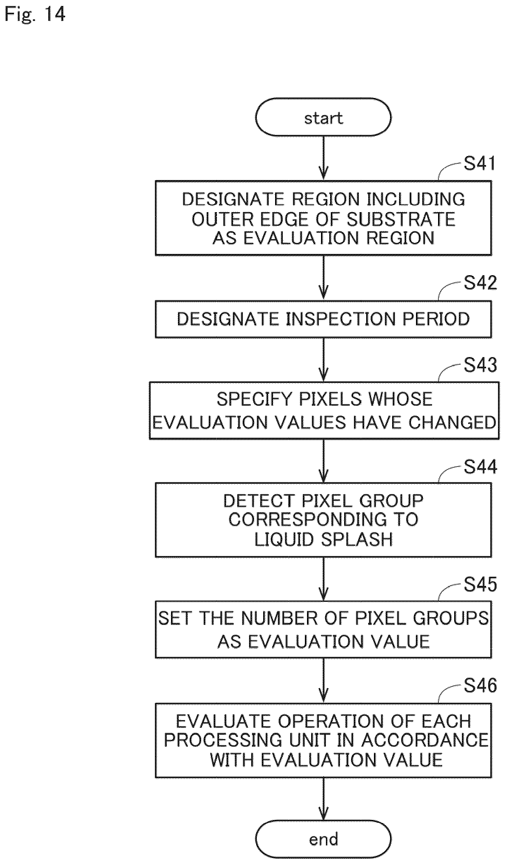

When the processing liquid is supplied to the surface of the substrate W during rotation of the substrate W, the processing liquid is scattered from the outer edge of the substrate W. At this time, a larger liquid splash of the processing liquid may be made in the vicinity of the chuck pins 22 than in other portions. The following description is given about the case of evaluating the state of this liquid splash. Fig. 14 is a flowchart showing a processing procedure performed when evaluating the state of the liquid splash.

As shown in Fig. 14, the controller 80 first designates an evaluation region (step S41). For example, the evaluation region may be designated in accordance with information that is input to the controller 80 by the user. In the present example, a region of the image capture region A that includes the outer periphery of the substrate W held by the substrate holder 20 is designated as the evaluation region.

Then, the controller 80 designates an inspection period (step S42). For example, the inspection period may be designated in accordance with information that is input to the controller 80 by the user. The inspection period is a duration of time greater than the time interval of acquiring the single data e by the event-based camera 70. In the case of evaluating the state of a liquid splash, the inspection period may be set to, for example, 0.1 seconds.

Then, the controller 80 specifies pixels whose luminance values have changed in the designated evaluation region during the designated inspection period (step S43). Specifically, the controller 80 specifies single data e that includes coordinate information x, y included in the designated evaluation region and time information t that matches the designated inspection period from among a plurality of pieces of single data e included in the event data E.

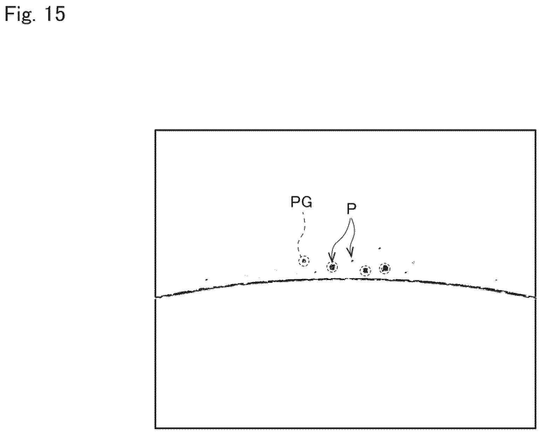

Fig. 15 is a diagram showing an example of pixels whose luminance values have changed during the above inspection period in the above evaluation region (these pixels are hereinafter referred to as "detected pixels P"). The controller 80 extracts, from among a plurality of detected pixels P, a pixel group PG in which the number of pixels adjacent to one another is greater than or equal to a predetermined lower limit value and less than or equal to a predetermined upper limit value. In this way, it is possible to detect an area that corresponds to a liquid splash as the pixel group PG (step S44). In Fig. 15, the detected pixel group PG is indicated by being surrounded by a broken circle.

In the example in Fig. 15, a large number of detected pixels P are linearly continuous in a portion that corresponds to the outer edge of the substrate W. However, this portion is not detected as a liquid splash because there is an upper limit value for the number of detected pixels P adjacent to one another.

The controller 80 counts the number of pixel groups PG detected as liquid splashes in the evaluation region (step S45). Then, the controller 80 sets the counted number of pixel groups PG as the evaluation value. Thereafter, the controller 80 evaluates the operation of each processing unit 102 in accordance with the evaluation value (step S46).

In step S46, the controller 80 compares the numbers of pixel groups PG counted for each processing unit 102. Then, the controller 80 determines whether a difference between the number of pixel groups PG counted for a processing unit 102 that serves as a reference and the number of pixel groups PG counted for a different processing unit 102 falls within a preset tolerance. If the difference between the numbers of pixel groups PG deviates from the tolerance, the controller 80 determines that there is a wide range of variations in operation (machine-to-machine difference) between those processing units 102. Thereafter, the controller 80 displays the evaluation result on the display 84.

### 4-4. Case of Evaluating Drying Time

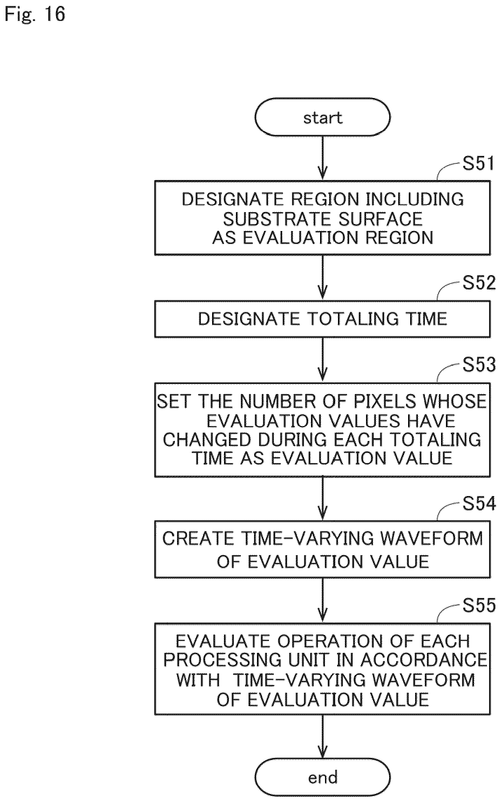

In step S4 described above, the surface of the substrate W is dried by rotating the substrate W at high speed so as to shake off the processing liquid. At this time, a liquid membrane of the processing liquid gradually decreases in thickness on the surface of the substrate W, and this causes a change in interference fringe of light. The following description is given about such a case of evaluating the surface state of the substrate W during dry processing. Fig. 16 is a flowchart showing a processing procedure performed when evaluating the surface state of the substrate W during dry processing.

As shown in Fig. 16, the controller 80 first designates an evaluation region (step S51). For example, the evaluation region may be designated in accordance with information that is input to the controller 80 by the user. In the present example, a region of the image capture region A that includes the surface of the substrate W during dry processing is designated as the evaluation region.

Then, the controller 80 designates a totaling time (step S52). For example, the totaling time may be designated in accordance with information that is input to the controller 80 by the user. The totaling time is a duration of time greater than the time interval of acquiring the single data e by the event-based camera 70. In the case of evaluating the surface sate of the substrate W during dry processing, the totaling time may be set to, for example, 0.1 seconds.

Then, the controller 80 counts the number of pixels whose luminance values have changed in the designated evaluation region during each designated totaling time. Specifically, the controller 80 totals the number of pieces of single data e that includes coordinate information x, y included in the designated evaluation region and time information t that matches the designated totaling time among a plurality of pieces of single data e included in the event data E. It is, however, noted that a plurality of pieces of single data e that include the same coordinate information x, y are counted as one piece of single data e. That is, even if the luminance value of one pixel has changed multiple times during one totaling time, the count is incremented just by one. Then, the controller 80 sets the totaled number of pieces of single data e (e.g., the number of pixels whose luminance values have changed) as the evaluation value (step S53).

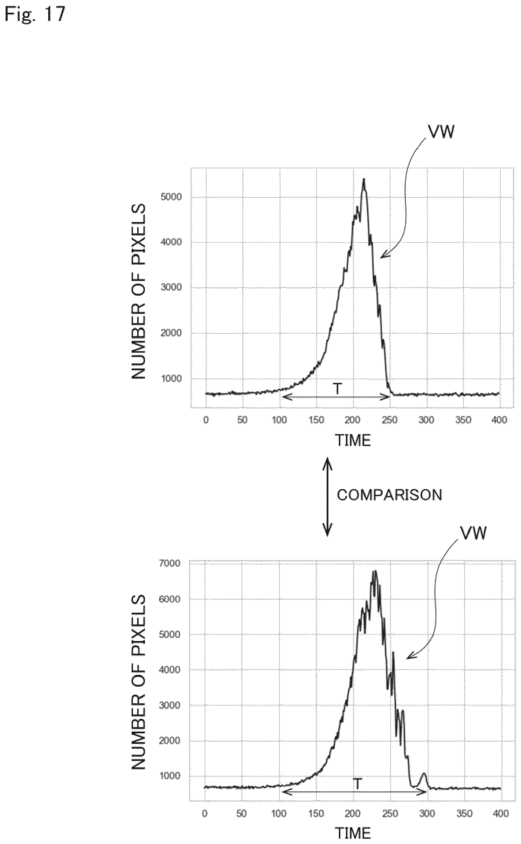

Then, the controller 80 creates a time-varying waveform VW of the above evaluation value (step S54). Fig. 17 is a graph showing time-varying waveforms VW created for two processing units 102. The horizontal axis in the graph shown in Fig. 17 represents the time. The vertical axis in the graph shown in Fig. 17 represents the number of pixels. That is, the graph in Fig. 17 shows the time-varying change in the number of pixels whose luminance values have changed among a plurality of pixels included in the evaluation region.

The controller 80 evaluates the operation of each processing unit 102 in accordance with the created time-varying waveform VW of the evaluation value (step S55). In step S55, the controller 80 measures a duration of time from when the evaluation value has started to increase to when the evaluation value has finished decreasing (hereinafter, referred to as "drying time T") from the time-varying waveform VW. Then, the controller 80 compares the drying time T measured for each processing unit 102. The controller 80 determines whether a difference between the drying time T measured for a processing unit 102 that serves as a reference and the drying time T measured for a different processing unit 102 falls within a preset tolerance. Then, if the difference in drying time T deviates from the tolerance, the controller 80 determines that there is a wide range of variations in operation (machine-to-machine difference) between those processing units 102. Thereafter, the controller 80 displays the evaluation result on the display 84.

### 4-5. Advantageous Effects of Operation Monitoring Method according to Present Embodiment

As described above, the substrate processing apparatus 100 shoots a specific operation of each processing unit 102 by using the event-based camera 70. Then, the evaluation value is calculated based on the obtained event data E. The event data E has recorded therein information about high-speed motion included in the operation of the processing unit 102. Accordingly, it is possible to evaluate the high-speed motion in accordance with the evaluation value.

In the operation monitoring method according to the present embodiment, processing for synchronizing the timing of the pieces of event data E with one another is performed in steps S12 and S 13 before the processing for calculating the evaluation value in step S14. By so doing, it is possible to calculate the evaluation value in accordance with a plurality of pieces event data E that have undergone the processing for synchronizing the timing of operations in step S14. As a result, variations in the operation of the processing units 102 can be evaluated more accurately in step S15.

In the operation monitoring method according to the present embodiment, the feature for use in synchronizing the timing of the pieces of event data E with one another is calculated based on the information included in the event data E. That is, the event data E for use in evaluating the operations of the processing units 102 is also used to synchronize the timing of the operations. This eliminates the need to measure, separately from the event data E, other parameters for use in synchronizing the timing of the pieces of event data E with one another. Accordingly, it is possible to reduce measurements necessary for operation monitoring.

### 5. Variations

While one embodiment of the present invention has been described thus far, the present invention is not intended to be limited to the above-described embodiment.

In the above-described embodiment, a specific operation performed in a plurality of processing units 102 is shot to evaluate variations in the specific operation performed in the processing units 102. Alternatively, an operation repeatedly performed in one processing unit 102 may be shot multiple times, and variations in the operation performed in the processing unit 102 may be evaluated in accordance with the obtained event data E.

The above-described embodiment gives an example of evaluating an operation of a processing unit 102 that supplies a processing liquid to the surfaces of substrates W. However, the processing unit to be evaluated may be any other unit that performs different processing on the substrates W. The objects to be processed may also be any substance other than the substrates W. The operation monitoring method according to the present invention is widely applicable to apparatus for performing processing that involves movements.

However, in apparatuses that supply a processing liquid to the substrates W such as semiconductor wafers for use in precision electronic components, it is necessary to extremely accurately manage the reproducibility of operations. Therefore, in particular, there is a high significance of applying the operation monitoring method according to the present invention to the apparatuses that supply the processing liquid to the substrates W.

### [Reference Signs List]

- 10: chamber
- 20: substrate holder
- 30: rotation mechanism
- 40: processing liquid supplier
- 50: processing liquid collector
- 60: barrier plate
- 70: event-based camera
- 80: controller
- 100: substrate processing apparatus
- 102: processing unit
- P1: operation control program
- P2: operation monitoring program
- W: substrate
- A: image capture region
- E: event data
- e: single data
- H1: histogram
- H2: histogram
- P: detected pixel
- PG: pixel group
- T: drying time
- WF: time-varying waveform of feature
- VW: time-varying waveform of evaluation value

## Claims

1. An operation monitoring method for monitoring an operation of a processing unit, the operation monitoring method comprising:
a) acquiring event data by shooting a specific operation of the processing unit by an event-based camera, the event data including information about only a pixel whose luminance value has changed;
b) calculating an evaluation value based on the event data; and
c) evaluating the specific operation of the processing unit in accordance with the evaluation value.

2. The operation monitoring method according to claim 1, wherein
in the operation a), a plurality of pieces of event data are acquired by shooting the specific operation performed in a plurality of processing units by the event-based camera, each of the plurality of pieces of event data being the event data, each of the plurality of processing units being the processing unit,
in the operation b), the evaluation value is calculated for each of the plurality pieces of event data, and
in the operation c), a variation in the specific operation of the plurality of processing units is evaluated in accordance with the evaluation value.

3. The operation monitoring method according to claim 2, further comprising:
x) calculating a feature based on the information per unit time for each of the plurality of pieces of event data; and
y) synchronizing timing of the plurality of pieces of event data with one another in accordance with a time-varying waveform of the feature,
the operations x) and y) being performed after the operation a) and before the operation b).

4. The operation monitoring method according to claim 3, wherein
the feature is the number of pixels whose luminance values have changed per unit time.

5. The operation monitoring method according to any one of claims 1 to 4, wherein
the evaluation value is the number of pixels whose luminance values have changed in a predetermined evaluation region during a predetermined totaling time.

6. The operation monitoring method according to claim 5, wherein
in the operation c), the specific operation of the processing unit is evaluated in accordance with a histogram obtained by totaling the number of pixels for each totaling time when there is a change in luminance value among a plurality of totaling times included in a predetermined inspection time, each of the plurality of totaling times being the predetermined totaling time.

7. The operation monitoring method according to claim 5 or 6, wherein
the processing unit is a unit that supplies a processing liquid to a surface of a substrate, and
the predetermined evaluation region includes the surface of the substrate during supply of the processing liquid.

8. The operation monitoring method according to claim 5 or 6, wherein
the processing unit is a unit that supplies a processing liquid to a surface of a substrate, and
the predetermined evaluation region includes a liquid column of the processing liquid ejected from a nozzle toward the substrate.

9. The operation monitoring method according to any one of claims 1 to 4, wherein
the evaluation value is the number of pixel groups in which the number of adj acent pixels whose luminance values have changed in a predetermined evaluation region during a predetermined inspection time is greater than or equal to a predetermined lower limit value and less than or equal to a predetermined upper limit value.

10. The operation monitoring method according to claim 9, wherein
the processing unit is a unit that supplies a processing liquid to a surface of a substrate, and
the predetermined evaluation region includes an outer edge of the substrate.

11. The operation monitoring method according to any one of claims 1 to 4, wherein
the evaluation value is the number of pixels whose luminance values have changed in a predetermined evaluation time during a predetermined totaling time, and
in the operation c), the specific operation of the processing unit is evaluated based on a time-varying change of the evaluation value.

12. The operation monitoring method according to claim 11, wherein
the processing unit is a unit that supplies a processing liquid to a surface of a substrate, and
the predetermined evaluation region includes the surface of the substrate during dry processing of shaking off the processing liquid while rotating the substrate.

13. A manufacturing apparatus comprising:
a processing unit that processes an object to be processed, by performing a specific operation;
an event-based camera capable of outputting event data that includes information about only a pixel whose luminance value has changed; and
a computer that is communicably connected to the event-based camera,
the manufacturing apparatus causing the computer to execute:
a) processing for acquiring the event data by causing the event-based camera to shoot the specific operation of the processing unit;
b) processing for calculating an evaluation value based on the event data; and
c) processing for evaluating the specific operation of the processing unit in accordance with the evaluation value.
